# EUROPEAN PATENT SPECIFICATION

(11) **EP 3 524 875 B1**
(45) Date of publication and mention of the grant of the patent: **11.05.2022**
(21) Application number: 18163525.1
(22) Date of filing: 23.03.2018
(51) Int. Cl.: F21V 7/00, F21V 9/08, F21V 7/04, F21V 29/70, F21S 4/26, F21Y 115/10, F21Y 103/10

(54) **FLEXIBLE LIGHT BELT APPARATUS**
FLEXIBLE LICHTSTREIFEN
BANDE LUMINEUSE FLEXIBLE

(30) Priority: 07.02.2018 CN 201820222332 U
(43) Date of publication of application: 14.08.2019
(73) Proprietor: Xiamen Eco Lighting Co., Ltd., Xiamen Fujian 363999 (CN)
(72) Inventor: Zeng, Maojin, Xiamen, Fujian 361010 (CN); Dong, Yongzhe, Xiamen, Fujian 361010 (CN); Deng, Wanfeng, Xiamen, Fujian 361010 (CN)
(74) Representative: Dilg, Haeusler, Schindelmann Patentanwaltsgesellschaft mbH

(56) References cited:
- EP-A1- 2 454 520
- EP-A1- 3 001 095
- EP-A1- 3 196 550
- CN-A- 105 937 718
- US-A1- 2012 212 954

## Description

### Technical Field

The present invention is related to a light belt apparatus and more particularly related to a light emitting diode (LED) light belt apparatus.

### Background Art

Artificial light is critical to human life today. Not only serving as luminous source in various building or outdoor environment, various light devices make human life better and better.

Some lights may be designed for decorative purpose while some others may be designed for emphasizing portability. There are also many factors to consider, e.g. heat dissipation, luminous efficacy, robustness of products, life span.

US 2012/0212954 A1 describes an illumination device capable of providing uniform illumination along a specific direction.

EP 3196550 A discloses a lighting device.

CN 105 937 718 A describes an extruded side-emitting light bar and a production method for the same.

It is important to design useful and reliable light components so that light designers may rely on such light components to build more interesting and helpful products.

### Disclosure of the Invention

According to an embodiment of the present invention, as disclosed in claim 1, a light belt apparatus includes a base belt, a flexible circuit board, multiple LED modules, and an input terminal.

The base belt is made of plastic material and has an elongated flexible body. The elongated flexible body has an elongated groove with a first side and a second side. The first side and the second side are opposite to each other. The flexible circuit board is attached to the first side of the base belt.

The LED modules are mounted on the flexible circuit board. The LED modules emit an emitted light to the second side of the base belt. The second side of the base belt has a reflective curve surface reflecting the emitted light to exit the groove.

The input terminal electrically is connected to the flexible circuit board for supplying electricity power to the LED modules to generate the emitted light.

The apparatus further comprises a light diffusion layer covering the elongated groove.

The first side is connected with the second side with a bottom side in the elongated groove, and the reflective curve surface is extended from the bottom side to the second side to reflect the emitted light toward the bottom side and the second side to exit the elongated groove, wherein the second side has a vertical part and a curve part, the curve part is connected to the bottom side, the vertical part is substantially parallel to the first side.

The apparatus further comprises a transparent material filled in the elongated groove facing to the first side and the second side.

In some embodiments, the LED modules have a series of LED chips arranged in series and a constant current source is provided to the LED chips. In some design, the LED chips are connected in series, in parallel or in any combination so that no further driver circuit is necessary to keep the LED module working.

Each LED module may contain one or more than one LED chips packaged with various technologies, including but not limited to SMD (Surface Mounted Device), COB (Chip on Board), Flip Chip, CSP (Chip Scale Package).

In some embodiments, the base belt is made of an elongated plastic bar with a trench as the elongated groove. An elongated flexible circuit board mounted with LED chips is attached to a side of the trench. The emitted light from the LED chips are reflected by the side wall of the trench to the outside. Some protective or diffusion layer may be added above the trench.

Please be noted that the inventive concept may also extend to rigid light belt structures. In some embodiments, the first side of the elongated groove is connected with the second side with a bottom side in the elongated groove. The reflective curve surface is extended from the bottom side to the second side to reflect the emitted light toward the bottom side and the second side to exit the elongated groove.

According to the invention, the second side has a vertical part and a curve part. The curve part is connected to the bottom side, and the vertical part is substantially parallel to the first side. In other words, there is a curve surface forming in the connection part of the second side and the bottom side of the elongated groove. When light is emitted downwardly to the reflective curve surface, the light is reflected to leave the elongated groove or reflected to other part of the elongated groove and finally leaves the elongated groove.

According to the invention, the curve part of the second side and the bottom side form a smooth convex curve surface facing to the LED modules. Such convex surface form a concave mirror to reflect light emitted on the concave mirror to a desired direction, e.g. to leave the elongated groove.

In some embodiments, the second side of the elongated groove has a tilt angle with respect to the first side, and the tilt angle is less than 60 degrees. Compared with previous embodiments, where the second side still has a vertical part in parallel to the first side, in these embodiments, the second side is directly a tilt surface for reflecting light outside the elongated groove. The second side may also have a convex curve surface at its bottom, just like the previous embodiments.

In such embodiments, more light is directly reflected and directed outside the elongated groove.

In some embodiments, the reflective curve surface has a reflective layer. In other words, not depending on original material of the base belt, the reflective curve surface has a better reflective effect by adding a reflective layer.

In some embodiments, the reflective layer is made of paint material attached on the second side as the reflective curve surface. For example, a silver or white color paint is applied on the reflective surface.

In some embodiments, the reflective layer is a reflective component attached on the second side of the elongated groove. For example, a reflective paper, a reflective metal sheet, a reflective plastic sheet may be used in the invention.

In some embodiments, the reflective component assists heat dissipation. When light is emitted on the reflective component, there is certain heat to be removed. The reflective component may be further attached to an external heat sink or just dissipate heat to make the light belt more robust with longer life span.

In some embodiments, the light belt apparatus also include a light diffusion layer covering the elongated groove. With the light diffusion layer, the light would not be too aggressive, harming human eyes.

In some embodiments, the light diffusion layer may be mixed with color material for providing a required color.

In some embodiments, the top surface of the light diffusion layer has a curve surface.

This may produce lens effect to guide output light as a more helpful pattern in various applications.

In some embodiments, the light belt apparatus may further include a transparent material filled in the elongated groove facing to the first side and the second side. Unlike filling the diffusion layer material directly in the elongated groove, such transparent material may further increase luminous efficacy.

In some embodiments, the LED modules may have multiple LED types, i.e. having different parameters. Different LED modules are distributed on the flexible circuit board in a predetermined order and arrangement for generating a synthesized light effect.

For example, the LED modules may have LED chips with different color temperatures. By mixing LED chips with different color temperature, a mixed color temperature may better meet the requirement of light design.

In some other embodiments, the LED modules may have LED chips with different colors, e.g. to provide better CRI (Color Rendering Index).

In some embodiments, the light belt apparatus may further include a driver circuit for converting electricity from the input terminal to a driving current of the LED modules. With such design, designers do not need to further implement an external driver but to connect the light belt apparatus to a power source.

In some embodiments, the flexible circuit board may have a reflective surface for reflecting light. When the light is reflected from the second side of the elongated groove, the flexible circuit board may further reflect the light to another direction, so as to increase final overall luminous efficacy.

### Brief Description of Drawings

Fig. 1 illustrates a light belt apparatus embodiment.
Fig. 2 is a diagram explaining inner structure of a light belt apparatus embodiment.
Fig. 3 is a diagram explaining inner structure of another light belt apparatus embodiment.
Fig. 4 illustrates another light belt apparatus embodiment.
Fig. 5 is a diagram explaining inner structure of a light belt embodiment.
Fig. 6 is a diagram explaining inner structure of another light belt embodiment.

### Detailed Description of Embodiments

According to an embodiment of the present invention, a light belt apparatus includes a base belt, a flexible circuit board, multiple LED modules, and an input terminal.

The base belt is made of plastic material and has an elongated flexible body. The elongated flexible body has an elongated groove with a first side and a second side. The first side and the second side are opposite to each other.

The flexible circuit board is attached to the first side of the base belt.

The LED modules are mounted on the flexible circuit board. The LED modules emit an emitted light to the second side of the base belt. The second side of the base belt has a reflective curve surface reflecting the emitted light to exit the groove.

The input terminal electrically is connected to the flexible circuit board for supplying electricity power to the LED modules to generate the emitted.

In some embodiments, the LED modules have a series of LED chips arranged in series and a constant current source is provided to the LED chips. In some design, the LED chips are connected in series, in parallel or in any combination so that no further driver circuit is necessary to keep the LED module working.

Each LED module may contain one or more than one LED chips packaged with various technologies, including but not limited to SMD (Surface Mounted Device), COB (Chip on Board), Flip Chip, CSP (Chip Scale Package).

In some embodiments, the base belt is made of an elongated plastic bar with a trench as the elongated groove. An elongated flexible circuit board mounted with LED chips is attached to a side of the trench. The emitted light from the LED chips are reflected by the side wall of the trench to the outside. Some protective or diffusion layer may be added above the trench.

Please be noted that the inventive concept may also extend to rigid light belt structures. In some embodiments, the first side of the elongated groove is connected with the second side with a bottom side in the elongated groove. The reflective curve surface is extended from the bottom side to the second side to reflect the emitted light toward the bottom side and the second side to exit the elongated groove.

According to the invention, the second side has a vertical part and a curve part. The curve part is connected to the bottom side, and the vertical part is substantially parallel to the first side. In other words, there is a curve surface forming in the connection part of the second side and the bottom side of the elongated groove. When light is emitted downwardly to the reflective curve surface, the light is reflected to leave the elongated groove or reflected to other part of the elongated groove and finally leaves the elongated groove.

According to the invention, the curve part of the second side and the bottom side form a smooth convex curve surface facing to the LED modules. Such convex surface form a concave mirror to reflect light emitted on the concave mirror to a desired direction, e.g. to leave the elongated groove.

In some embodiments, the second side of the elongated groove has a tilt angle with respect to the first side, and the tilt angle is less than 60 degrees. Compared with previous embodiments, where the second side still has a vertical part in parallel to the first side, in these embodiments, the second side is directly a tilt surface for reflecting light outside the elongated groove. The second side may also have a convex curve surface at its bottom, just like the previous embodiments.

In such embodiments, more light is directly reflected and directed outside the elongated groove.

In some embodiments, the reflective curve surface has a reflective layer. In other words, not depending on original material of the base belt, the reflective curve surface has a better reflective effect by adding a reflective layer.

In some embodiments, the reflective layer is made of paint material attached on the second side as the reflective curve surface. For example, a silver or white color paint is applied on the reflective surface.

In some embodiments, the reflective layer is a reflective component attached on the second side of the elongated groove. For example, a reflective paper, a reflective metal sheet, a reflective plastic sheet may be used in the invention.

In some embodiments, the reflective component assists heat dissipation. When light is emitted on the reflective component, there is certain heat to be removed. The reflective component may be further attached to an external heat sink or just dissipate heat to make the light belt more robust with longer life span.

In some embodiments, the light belt apparatus also include a light diffusion layer covering the elongated groove. With the light diffusion layer, the light would not be too aggressive, harming human eyes.

In some embodiments, the light diffusion layer may be mixed with color material for providing a required color.

In some embodiments, the top surface of the light diffusion layer has a curve surface.

This may produce lens effect to guide output light as a more helpful pattern in various applications.

In some embodiments, the light belt apparatus may further include a transparent material filled in the elongated groove facing to the first side and the second side. Unlike filling the diffusion layer material directly in the elongated groove, such transparent material may further increase luminous efficacy.

In some embodiments, the LED modules may have multiple LED types, i.e. having different parameters. Different LED modules are distributed on the flexible circuit board in a predetermined order and arrangement for generating a synthesized light effect.

For example, the LED modules may have LED chips with different color temperatures. By mixing LED chips with different color temperature, a mixed color temperature may better meet the requirement of light design.

In some other embodiments, the LED modules may have LED chips with different colors, e.g. to provide better CRI (Color Rendering Index).

In some embodiments, the light belt apparatus may further include a driver circuit for converting electricity from the input terminal to a driving current of the LED modules. With such design, designers do not need to further implement an external driver but to connect the light belt apparatus to a power source.

In some embodiments, the flexible circuit board may have a reflective surface for reflecting light. When the light is reflected from the second side of the elongated groove, the flexible circuit board may further reflect the light to another direction, so as to increase final overall luminous efficacy.

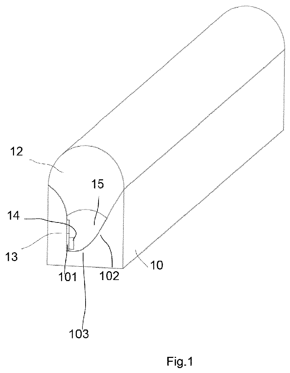

Please refer to Fig. 1, which illustrates a light belt apparatus embodiment.

In Fig. 1, as mentioned above, the light belt apparatus has a base belt 10, a diffusion layer 12, a transparent material 15, a flexible circuit board 13, and a LED module 14.

The LED module 14 is mounted on the flexible circuit board 13. The transparent material 15 is filled in an elongated groove of the base belt 10.

The elongated groove of the base belt 10 has a first side 101, a second side 102. The first side 101 is opposing to the second side 102. There is a bottom side 103 connecting the first side 101 and the second side 102. A reflective curve surface is existed in the second side for reflecting light emitted from the LED module 14.

The diffusion layer 12 covers on the transparent material and may combine with the base belt 10 for creating water proof effect.

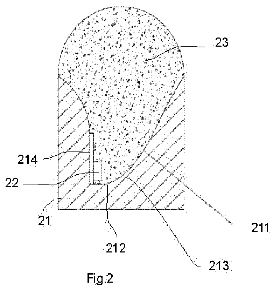

Please refer to Fig. 2, which illustrates an inner structure of a light belt apparatus.

In Fig. 2, there is no transparent material as in Fig. 1. The material of the diffusion layer 23 directly fills in the elongated groove. The LED module emits light to the reflective curve surface 213, which is partly the bottom side 212 of the elongated groove and partly the second side 211. The first side 214 may also be prepared with reflective effect for enhancing luminous efficacy.

It is clear that the second side 211 has a tilt angle with respect to the first side 214. The tilt angle may be 45 degrees, or less than 60 degrees for most cases, to reflect light emitted thereon outside the groove. The diffusion layer 23 helps render output light soft and smooth.

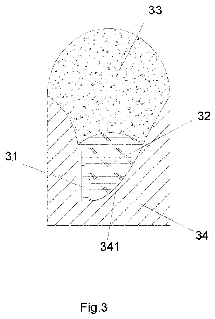

Please refer to Fig. 3, which illustrates an inner structure of a light belt apparatus.

In Fig. 3, there is transparent material filled in an elongated groove of the base belt 34. With the transparent material, light has better luminous efficacy before hitting the reflective curve surface 341. The reflected light is also influenced by the diffusion layer 33 to generate soft luminous effect.

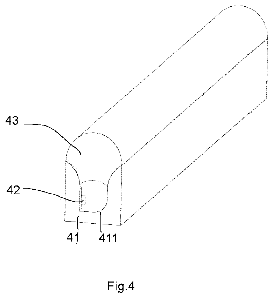

Please refer to Fig. 4, which illustrates another light belt apparatus embodiment.

In Fig. 4, there is still a base belt 41, LED modules 42 and a diffusion layer 43 covering the base belt 41. There is also a reflective curve surface in the elongated groove of the base belt 41, but they have less tilt angle as the embodiment in Fig. 1. The second side is substantially parallel to the first side of the elongated groove, but with a curve part at its bottom connecting to the bottom side of the elongated groove.

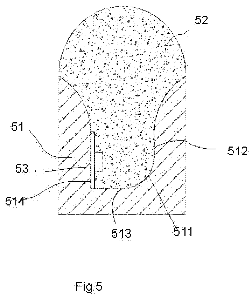

Please refer to Fig. 5, which illustrates a light belt apparatus embodiment.

In Fig. 5, the base belt 51 has a first side 514, a second 512, and a bottom side. The LED module 53 emits light to the second side 512. A reflective curve surface 511 exists between at the bottom of the second side 512 and the bottom side 513. The diffusion layer 52 helps soften the output light effect.

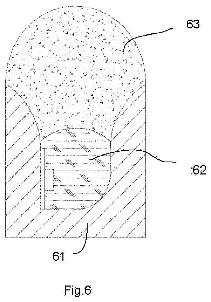

Please refer to Fig. 6, which illustrates another light belt embodiment.

In Fig. 6, the embodiment is similar to the embodiment of Fig. 5. In addition, there is a transparent material 62 filled in the elongated groove of the base belt 61. The transparent material 62 is then covered by the diffusion layer 63 to keep the overall soft light effect while increasing total luminous efficacy.

## Claims

1. A light belt apparatus, comprising:
a base belt (10) made of plastic material and having an elongated flexible body, the elongated flexible body having an elongated groove with a first side (101) and a second side (102), the first side (101) and the second side (102) being opposite to each other;
a flexible circuit board (13) attached to the first side (101) of the base belt (10);
a plurality of light emitting diode (LED) modules (14) mounted on the flexible circuit board (13), the plurality of LED modules (14) for emitting an emitted light to the second side (102) of the base belt (10), the second side (102) of the base belt (10) having a reflective curve surface reflecting the emitted light to exit the groove;
an input terminal electrically connected to the flexible circuit board (13) for supplying electricity power to the LED modules (14) to generate the emitted light; and
a light diffusion layer (12) covering the elongated groove;
**characterized in that** the first side (101) is connected with the second side (102) with a bottom side (103) in the elongated groove, and the reflective curve surface is extended from the bottom side (103) to the second side (102) to reflect the emitted light toward the bottom side (103) and the second side (102) to exit the elongated groove, wherein the second side (102) has a vertical part and a curve part, the curve part is connected to the bottom side (103), the vertical part is substantially parallel to the first side (101);
further comprising a transparent material (15) filled in the elongated groove facing to the first side (101) and the second side (102); and
wherein the curve part of the second side (102) and the bottom side (103) form a smooth convex curve surface facing to the LED modules (14).

2. The light belt apparatus of claim 1, **characterized in that** the second side (102) has a tilt angle with respect to the first side (101), and the tilt angle is less than 60 degrees.

3. The light belt apparatus of claim 2, **characterized in that** the second side (102) has a concave surface connected to the smooth convex curve surface.

4. The light belt apparatus of any one of claims 1 to 3, **characterized in that** the reflective curve surface has a reflective layer.

5. The light belt apparatus of claim 4, **characterized in that** the reflective layer is made of paint material attached on the second side (102) as the reflective curve surface.

6. The light belt apparatus of claim 4 or 5, **characterized in that** the reflective layer is a reflective component attached on the second side (102) of the elongated groove, preferably, the reflective component assists heat dissipation.

7. The light belt apparatus of any one of claims 1 to 6, **characterized in that** the light diffusion layer (12) is mixed with a color material for providing a required color, preferably, the top surface of the light diffusion layer (12) has a curve surface.

8. The light belt apparatus of any one of claims 1 to 7, **characterized in that** the LED modules (14) have a plurality of LED types, distributed on the flexible circuit board (13) for generating a synthesized light effect by the plurality of LED types, preferably the LED modules (14) comprise LED chips with different color temperatures, or preferably, the LED modules (14) comprise LED chips with different colors.

9. The light belt apparatus of any one of claims 1 to 8, **characterized by** further comprising a driver circuit for converting electricity from the input terminal to a driving current of the LED modules (14).

10. The light belt apparatus of any one of claims 1 to 9, **characterized in that** the flexible circuit board (13) has a reflective surface for reflecting light emitted on the reflective surface.

## Patentansprüche

1. Eine Lichtstreifenvorrichtung, aufweisend:
einen Basisstreifen (10), der aus Kunststoffmaterial hergestellt ist und einen länglichen flexiblen Körper aufweist, wobei der längliche flexible Körper eine längliche Nut mit einer ersten Seite (101) und einer zweiten Seite (102) aufweist, wobei die erste Seite (101) und die zweite Seite (102) einander gegenüberliegen;
eine flexible Leiterplatte (13), die an der ersten Seite (101) des Basisstreifens (10) angebracht ist;
eine Mehrzahl von Leuchtdioden-(LED)-Modulen (14), die auf der flexiblen Leiterplatte (13) angebracht sind, wobei die Mehrzahl von LED-Modulen (14) zum Emittieren eines emittierten Lichts zu der zweiten Seite (102) des Basisstreifens (10) eingerichtet ist, wobei die zweite Seite (102) des Basisstreifens (10) eine reflektierende gekrümmte Oberfläche aufweist, die das emittierte Licht zum Austreten aus der Nut reflektiert;
einen Eingangsanschluss, der elektrisch mit der flexiblen Leiterplatte (13) verbunden ist, um die LED-Module (14) mit elektrischer Energie zu versorgen, um das emittierte Licht zu erzeugen; und
eine lichtstreuende Schicht (12), die die längliche Nut bedeckt;
**dadurch gekennzeichnet, dass** die erste Seite (101) durch eine Bodenseite (103) in der länglichen Nut mit der zweiten Seite (102) verbunden ist und dass die reflektierende gekrümmte Oberfläche sich von der Bodenseite (103) zu der zweiten Seite (102) erstreckt, um das emittierte Licht in Richtung der Bodenseite (103) und der zweiten Seite (102) zu reflektieren, um aus der länglichen Nut auszutreten, wobei die zweite Seite (102) einen vertikalen Teil und einen gekrümmten Teil aufweist, wobei der gekrümmte Teil mit der Bodenseite (103) verbunden ist und wobei der vertikale Teil im Wesentlichen parallel zu der ersten Seite (101) ist;
ferner aufweisend ein transparentes Material (15), das in die der ersten Seite (101) und der zweiten Seite (102) zugewandte längliche Nut gefüllt ist; und
wobei der gekrümmte Teil der zweiten Seite (102) und die Bodenseite (103) eine glatte konvexe gekrümmte Fläche bilden, die den LED-Modulen (14) zugewandt ist.

2. Die Lichtstreifenvorrichtung nach Anspruch 1, **dadurch gekennzeichnet, dass** die zweite Seite (102) einen Neigungswinkel in Bezug auf die erste Seite (101) aufweist, und wobei der Neigungswinkel weniger als 60 Grad beträgt.

3. Die Lichtstreifenvorrichtung nach Anspruch 2, **dadurch gekennzeichnet, dass** die zweite Seite (102) eine konkave Oberfläche aufweist, die mit der glatten konvexen gekrümmten Oberfläche verbunden ist.

4. Die Lichtstreifenvorrichtung nach einem der Ansprüche 1 bis 3, **dadurch gekennzeichnet, dass** die reflektierende gekrümmte Oberfläche eine reflektierende Schicht aufweist.

5. Die Lichtstreifenvorrichtung nach Anspruch 4, **dadurch gekennzeichnet, dass** die reflektierende Schicht aus Farbmaterial besteht, das auf der zweiten Seite (102) als die reflektierende gekrümmte Oberfläche angebracht ist.

6. Die Lichtstreifenvorrichtung nach Anspruch 4 oder 5, **dadurch gekennzeichnet, dass** die reflektierende Schicht ein reflektierendes Bauteil ist, das auf der zweiten Seite (102) der länglichen Nut angebracht ist, wobei das reflektierende Bauteil vorzugsweise eine Wärmeabfuhr unterstützt.

7. Die Lichtstreifenvorrichtung nach einem der Ansprüche 1 bis 6, **dadurch gekennzeichnet, dass** die lichtstreuende Schicht (12) mit einem Farbmaterial gemischt ist, um eine gewünschte Farbe zu erzeugen, wobei die obere Oberfläche der lichtstreuenden Schicht (12) vorzugsweise eine gekrümmte Oberfläche aufweist.

8. Die Lichtstreifenvorrichtung nach einem der Ansprüche 1 bis 7, **dadurch gekennzeichnet, dass** die LED-Module (14) eine Mehrzahl von LED-Typen aufweisen, die zum Erzeugen eines synthetischen Lichteffekts durch die Mehrzahl von LED-Typen auf der flexiblen Leiterplatte (13) verteilt ist, wobei die LED-Module (14) vorzugsweise LED-Chips mit unterschiedlichen Farbtemperaturen aufweisen, oder wobei die LED-Module (14) vorzugsweise LED-Chips mit unterschiedlichen Farben aufweisen.

9. Die Lichtstreifenvorrichtung nach einem der Ansprüche 1 bis 8, **dadurch gekennzeichnet, dass** sie ferner eine Treiberschaltung zur Umwandlung von Elektrizität von dem Eingangsanschluss in einen Treiberstrom für die LED-Module (14) aufweist.

10. Die Lichtstreifenvorrichtung nach einem der Ansprüche 1 bis 9, **dadurch gekennzeichnet, dass** die flexible Leiterplatte (13) eine reflektierende Oberfläche zum Reflektieren von Licht, das auf die reflektierende Oberfläche emittiert wurde, aufweist.

## Revendications

1. Un appareil formant bande lumineuse, comprenant :
une bande de base (10) faite de matière plastique et ayant un corps flexible allongé, le corps flexible allongé ayant une rainure allongée avec un premier côté (101) et un deuxième côté (102), le premier côté (101) et le deuxième côté (102) étant opposés l'un à l'autre ;
une carte à circuit (13) flexible fixée au premier côté (101) de la bande de base (10) ;
une pluralité de modules de diodes électroluminescentes (DEL) (14) montés sur la carte à circuit (13) flexible, la pluralité de modules de DEL (14) étant prévue pour émettre une lumière émise vers le deuxième côté (102) de la bande de base (10), le deuxième côté (102) de la bande de base (10) ayant une surface courbe réfléchissante réfléchissant la lumière émise pour sortir de la rainure ;
une borne d'entrée connectée électriquement à la carte à circuit (13) flexible pour fournir de l'énergie électrique aux modules de DEL (14) afin de générer la lumière émise ; et
une couche (12) de diffusion de lumière recouvrant la rainure allongée ;
**caractérisé en ce que** le premier côté (101) est relié au deuxième côté (102) avec un côté inférieur (103) dans la rainure allongée, et la surface courbe réfléchissante s'étend depuis le côté inférieur (103) jusqu'au deuxième côté (102) de façon à réfléchir la lumière émise vers le côté inférieur (103) et le deuxième côté (102) pour sortir de la rainure allongée, le deuxième côté (102) ayant une partie verticale et une partie courbe, la partie courbe étant reliée au côté inférieur (103) la partie verticale étant sensiblement parallèle au premier côté (101) ;
comprenant en outre un matériau transparent (15) qui remplit la rainure allongée faisant face au premier côté (101) et au deuxième côté (102) ; et dans lequel la partie courbe du deuxième côté (102) et le côté inférieur (103) forment une surface courbe convexe lisse tournée vers les modules de DEL (14).

2. L'appareil formant bande lumineuse selon la revendication 1, **caractérisé en ce que** le deuxième côté (102) a un angle d'inclinaison par rapport au premier côté (101), et l'angle d'inclinaison est inférieur à 60 degrés.

3. L'appareil formant bande lumineuse selon la revendication 2, **caractérisé en ce que** le deuxième côté (102) a une surface concave reliée à la surface courbe convexe lisse.

4. L'appareil formant bande lumineuse selon l'une quelconque des revendications 1 à 3, **caractérisé en ce que** la surface courbe réfléchissante a une couche réfléchissante.

5. L'appareil formant bande lumineuse selon la revendication 4, **caractérisé en ce que** la couche réfléchissante est constituée d'un matériau de peinture fixé sur le deuxième côté (102) en tant que surface courbe réfléchissante.

6. L'appareil formant bande lumineuse selon la revendication 4 ou la revendication 5, **caractérisé en ce que** la couche réfléchissante est un composant réfléchissant fixé sur le deuxième côté (102) de la rainure allongée, de préférence, le composant réfléchissant aide à la dissipation de chaleur.

7. L'appareil formant bande lumineuse selon l'une quelconque des revendications 1 à 6, **caractérisé en ce que** la couche (12) de diffusion de lumière est mélangée avec un matériau de couleur pour fournir une couleur requise, de préférence, la surface supérieure de la couche (12) de diffusion de lumière a une surface courbe.

8. L'appareil formant bande lumineuse selon l'une quelconque des revendications 1 à 7, **caractérisé en ce que** les modules de DEL (14) ont une pluralité de types de DEL, répartis sur la carte à circuit (13) flexible pour générer un effet lumineux synthétisé par la pluralité de types de DEL, de préférence les modules de DEL (14) comprennent des puces de DEL avec différentes températures de couleur, ou de préférence, les modules de DEL (14) comprennent des puces de DEL avec différentes couleurs.

9. L'appareil formant bande lumineuse selon l'une quelconque des revendications 1 à 8, **caractérisé en ce qu'**il comprend en outre un circuit de pilotage pour convertir l'électricité de la borne d'entrée en un courant de pilotage des modules de DEL (14).

10. L'appareil formant bande lumineuse selon l'une quelconque des revendications 1 à 9, **caractérisé en ce que** la carte à circuit (13) flexible a une surface réfléchissante pour réfléchir la lumière émise sur la surface réfléchissante.
